(19) Europäisches Patentamt
European Patent Office
Office européen des brevets

(11) **EP 3 802 895 B1**

(12) **FASCICULE DE BREVET EUROPEEN**

(45) Date de publication et mention de la délivrance du brevet:
**12.10.2022 Bulletin 2022/41**

(21) Numéro de dépôt: **19744760.0**

(22) Date de dépôt: **04.06.2019**

(51) Classification Internationale des Brevets (IPC):
*C22C 19/05* $^{(2006.01)}$     *C30B 1/00* $^{(2006.01)}$
*F01D 5/28* $^{(2006.01)}$

(52) Classification Coopérative des Brevets (CPC):
**C22C 19/057; C30B 29/52; F01D 5/28;**
F05D 2300/175; F05D 2300/607; Y02T 50/60

(86) Numéro de dépôt international:
**PCT/FR2019/051319**

(87) Numéro de publication internationale:
**WO 2019/234345 (12.12.2019 Gazette 2019/50)**

(54) **SUPERALLIAGE A BASE DE NICKEL, AUBE MONOCRISTALLINE ET TURBOMACHINE**

SUPERLEGIERUNG AUF NICKELBASIS, EINKRISTALLINE SCHAUFEL UND TURBOMASCHINE

NICKEL-BASED SUPERALLOY, SINGLE-CRYSTAL BLADE AND TURBOMACHINE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.06.2018 FR 1854819**

(43) Date de publication de la demande:
**14.04.2021 Bulletin 2021/15**

(73) Titulaires:
• **SAFRAN**
**75015 Paris (FR)**
• **Centre national de la recherche scientifique**
**75016 Paris (FR)**
• **UNIVERSITE DE POITIERS**
**86034 Poitiers Cedex (FR)**
• **Ecole Nationale Superieure de Mecanique Aerotechnique**
**86961 Futuroscope-Chasseneuil Cedex (FR)**

(72) Inventeurs:
• **RAME, Jérémy**
**77550 MOISSY-CRAMAYEL (FR)**
• **CORMIER, Jonathan**
**86360 CHASSENEUIL DU POITOU (FR)**

(74) Mandataire: **Cabinet Beau de Loménie**
**158, rue de l'Université**
**75340 Paris Cedex 07 (FR)**

(56) Documents cités:
WO-A1-2018/078246     WO-A1-2018/078269
US-A- 5 888 451     US-A1- 2018 066 340

## Description

Domaine technologique

Le présent exposé concerne des superalliages à base de nickel pour des turbines à gaz, notamment pour les aubes fixes, aussi appelées distributeurs ou redresseurs, ou mobiles d'une turbine à gaz, par exemple dans le domaine de l'aéronautique.

Arrière-plan technologique

Il est connu d'utiliser des superalliages à base de nickel pour la fabrication d'aubes monocristallines fixes ou mobiles de turbines à gaz pour moteurs d'avion ou d'hélicoptère.

Ces matériaux ont pour principaux avantages de combiner à la fois une résistance au fluage élevée à haute température ainsi qu'une résistance à l'oxydation et à la corrosion.

Au cours du temps, les superalliages à base de nickel pour aubes monocristallines ont subi d'importantes évolutions de composition chimique, dans le but notamment d'améliorer leurs propriétés en fluage à haute température tout en conservant une résistance à l'environnement très agressif dans lesquels ces superalliages sont utilisés. WO2018/078246 décrit un superalliage à base de nickel ne comprenant ni platine, ni hafnium.

Par ailleurs, des revêtements métalliques adaptés à ces alliages ont été développés afin d'augmenter leur résistance à l'environnement agressif dans lequel ces alliages sont utilisés, notamment la résistance à l'oxydation et la résistance à la corrosion. De plus, un revêtement céramique de faible conductivité thermique, remplissant une fonction de barrière thermique, peut être ajouté pour réduire la température à la surface du métal.

Typiquement, un système de protection complet comporte au moins deux couches.

La première couche, aussi appelée sous-couche ou couche de liaison, est directement déposée sur la pièce à protéger en superalliage à base de nickel, aussi appelée substrat, par exemple une aube. L'étape de dépôt est suivie d'une étape de diffusion de la sous-couche dans le superalliage. Le dépôt et la diffusion peuvent également être réalisés lors d'une seule étape.

Les matériaux généralement utilisés pour réaliser cette sous-couche comprennent des alliages métalliques alumino-formeurs de type MCrAlY (M = Ni (nickel) ou Co (cobalt)) ou un mélange de Ni et de Co, Cr = chrome, Al = aluminium et Y = yttrium, ou des alliages de type aluminiure de nickel (NixAly), certains contenant également du platine (NixAlyPtz).

La deuxième couche, généralement appelée barrière thermique ou « TBC » conformément à l'acronyme anglais pour « Thermal Barrier Coating », est un revêtement céramique comprenant par exemple de la zircone yttriée, aussi appelée « YSZ » conformément à l'acronyme anglais pour « Yttria Stabilized Zirconia » ou « YPSZ » conformément à l'acronyme anglais pour « Yttria Partially Stabilized Zirconia » et présentant une structure poreuse. Cette couche peut être déposée par différents procédés, tels que l'évaporation sous faisceau d'électrons (« EB-PVD » conformément à l'acronyme anglais pour « Electron Beam Physical Vapor Déposition »), la projection thermique (« APS » conformément à l'acronyme anglais pour « Atmospheric Plasma Spraying » ou « SPS » conformément à l'acronyme anglais pour « Suspension Plasma Spraying »), ou tout autre procédé permettant d'obtenir un revêtement céramique poreux à faible conductivité thermique.

Du fait de l'utilisation de ces matériaux à haute température, par exemple de 650°C à 1150°C, il se produit des phénomènes d'inter-diffusion à l'échelle microscopique entre le superalliage à base de nickel du substrat et l'alliage métallique de la sous-couche. Ces phénomènes d'inter-diffusion, associés à l'oxydation de la sous-couche, modifient notamment la composition chimique, la microstructure et par conséquent les propriétés mécaniques de la sous-couche dès la fabrication du revêtement, puis pendant l'utilisation de l'aube dans la turbine. Ces phénomènes d'inter-diffusion modifient également la composition chimique, la microstructure et par conséquent les propriétés mécaniques du superalliage du substrat sous le revêtement. Dans les superalliages très chargés en éléments réfractaires, notamment en rhénium, il peut ainsi se former dans le superalliage sous la sous-couche une zone de réaction secondaire (ZRS) sur une profondeur de plusieurs dizaines, voire centaines, de micromètres. Les caractéristiques mécaniques de cette ZRS sont nettement inférieures à celles du superalliage du substrat. La formation de ZRS est indésirable car elle conduit à une réduction significative de la résistance mécanique du superalliage.

Ces évolutions de la couche de liaison, associées aux champs de contraintes liés à la croissance de la couche d'alumine qui se forme en service à la surface de cette couche de liaison, aussi appelée « TGO » conformément à l'acronyme anglais pour « Thermally Grown Oxide », et aux écarts de coefficients de dilatation thermique entre les différentes couches, génèrent des décohésions dans la zone interfaciale entre la sous-couche et le revêtement céramique, qui peuvent conduire à l'écaillage partiel ou total du revêtement céramique. La partie métallique (substrat en superalliage et sous-couche métallique) est alors mise à nu et exposée directement aux gaz de combustion, ce qui augmente les risques d'endommagement de l'aube et donc de la turbine à gaz.

De plus, la complexité de la chimie de ces alliages peut conduire à une déstabilisation de leur microstructure optimale avec l'apparition de particules de phases indésirables lors de maintiens à haute température des pièces formées à partir de ces alliages. Cette déstabilisation a des conséquences négatives sur les propriétés mécaniques de ces alliages. Ces phases indésirables de structure cristalline complexe et de nature fragile sont dénommées phases topologiquement compactes (« PTC ») ou phases « TCP » conformément au sigle anglais pour « Topologically Close-Packed ».

En outre, des défauts de fonderie sont susceptibles de se former dans les pièces, telles que des aubes, lors de leur fabrication par solidification dirigée. Ces défauts sont généralement des grains parasites du type « Freckle », dont la présence peut provoquer une rupture prématurée de la pièce en service. La présence de ces défauts, liés à la composition chimique du superalliage, conduit généralement au rejet de la pièce, ce qui entraîne une augmentation du coût de production.

Présentation

Le présent exposé vise à proposer des compositions de superalliages à base de nickel pour la fabrication de composants monocristallins, présentant des performances accrues en terme de durée de vie et de résistance mécanique et permettant de réduire les coûts de production de la pièce (diminution du taux de rebut) par rapport aux alliages existants. Ces superalliages présentent une résistance au fluage à haute température supérieure à celle des alliages existants tout en démontrant une bonne stabilité microstructurale dans le volume du superalliage (faible sensibilité à la formation de PTC), une bonne stabilité microstructurale sous la sous-couche de revêtement de la barrière thermique (faible sensibilité à la formation de ZRS), une bonne résistance à l'oxydation et à la corrosion tout en évitant la formation de grains parasites du type « Freckle ».

A cet effet, le présent exposé concerne un superalliage à base de nickel comprenant, en pourcentages massiques, 5,0 à 6,0 % d'aluminium, 6,0 à 9,5 % de tantale, 0 à 1,50 % de titane, 8,0 à 10,0 % de cobalt, 6,0 à 7,0 % de chrome, 0,30 à 0,90 % de molybdène, 5,5 à 6,5 % de tungstène, 0 à 2,50 % de rhénium, 0,05 à 0,15 % de hafnium, 0,70 à 4,30 % de platine, 0 à 0,15 % de silicium, le complément étant constitué par du nickel et des impuretés inévitables.

Ce superalliage est destiné à la fabrication de composants monocristallins de turbine à gaz, tels que des aubes fixes ou mobiles.

Grâce à cette composition du superalliage à base de nickel (Ni), la résistance au fluage est améliorée par rapport aux superalliages existants, en particulier à des températures pouvant aller jusqu'à 1200°C.

Cet alliage présente donc une résistance au fluage à haute température améliorée. Cet alliage présente également une résistance à la corrosion et à l'oxydation améliorée.

Ces superalliages présentent une masse volumique inférieure ou égale à 9,00 g/cm$^3$ (gramme par centimètre cube), de préférence inférieure ou égale à 8,85 g/cm$^3$.

Une pièce monocristalline en superalliage à base de nickel est obtenue par un procédé de solidification dirigée sous gradient thermique en fonderie à la cire perdue. Le superalliage monocristallin à base de nickel comprend une matrice austénitique de structure cubique à faces centrées, solution solide à base de nickel, dite phase gamma (« $\gamma$ »). Cette matrice contient des précipités de phase durcissante gamma prime (« $\gamma'$ ») de structure cubique ordonnée L1$_2$ de type Ni$_3$Al. L'ensemble (matrice et précipités) est donc décrit comme un superalliage $\gamma/\gamma'$.

Par ailleurs, cette composition du superalliage à base de nickel autorise la mise en œuvre d'un traitement thermique qui remet en solution les précipités de phase $\gamma'$ et les phases eutectiques $\gamma/\gamma'$ qui se forment lors de la solidification du superalliage. On peut ainsi obtenir un superalliage monocristallin à base de nickel contenant des précipités $\gamma'$ de taille contrôlée, de préférence comprise entre 300 et 500 nanomètres (nm), et contenant une faible proportion de phases eutectiques $\gamma/\gamma'$.

Le traitement thermique permet également de contrôler la fraction volumique des précipités de phase $\gamma'$ présente dans le superalliage monocristallin à base de nickel. Le pourcentage en volume des précipités de phase $\gamma'$ peut être supérieur ou égal à 50%, de préférence supérieur ou égal à 60%, encore plus de préférence égal à 70%.

Les éléments d'addition majeurs sont le cobalt (Co), le chrome (Cr), le molybdène (Mo), le rhénium (Re), le tungstène (W), l'aluminium (Al), le titane (Ti), le tantale (Ta) et le platine (Pt).

Les éléments d'addition mineurs sont le hafnium (Hf) et le silicium (Si), pour lesquels la teneur massique maximale est inférieure à 1 % en masse.

Parmi les impuretés inévitables, on peut citer, par exemple, le soufre (S), le carbone (C), le bore (B), l'yttrium (Y), le lanthane (La) et le cérium (Ce). On définit comme impuretés inévitables les éléments qui ne sont pas ajoutés de manière intentionnelle dans la composition et qui sont apportés avec d'autres éléments. Par exemple, le superalliage peut comprendre 0,005 % en masse de carbone.

L'addition de tungstène, de chrome, de cobalt, de rhénium ou de molybdène permet principalement de renforcer la matrice austénitique $\gamma$ de structure cristalline cubique à faces centrées (cfc) par durcissement en solution solide.

L'addition d'aluminium (Al), de titane (Ti) ou de tantale (Ta) favorise la précipitation de la phase durcissante $\gamma'$-

$Ni_3(Al, Ti, Ta)$.

Le rhénium (Re) permet de ralentir la diffusion des espèces chimiques au sein du superalliage et de limiter la coalescence des précipités de phase γ' en cours de service à haute température, phénomène qui entraîne une réduction de la résistance mécanique. Le rhénium permet ainsi d'améliorer la résistance au fluage à haute température du superalliage à base de nickel. Toutefois, une concentration trop élevée de rhénium peut entraîner la précipitation de phases intermétalliques PTC, par exemple phase σ, phase P ou phase μ, qui ont un effet négatif sur les propriétés mécaniques du superalliage. Une concentration trop élevée en rhénium peut également provoquer la formation d'une zone de réaction secondaire dans le superalliage sous la sous-couche, ce qui a un effet négatif sur les propriétés mécaniques du superalliage.

L'addition simultanée de silicium et de hafnium permet d'améliorer la tenue à l'oxydation à chaud des superalliages à base de nickel en augmentant l'adhérence de la couche d'alumine ($Al_2O_3$) qui se forme à la surface du superalliage à haute température. Cette couche d'alumine forme une couche de passivation en surface du superalliage à base de nickel et une barrière à la diffusion de l'oxygène venant de l'extérieur vers l'intérieur du superalliage à base de nickel. Toutefois on peut ajouter du hafnium sans ajouter également de silicium ou inversement ajouter du silicium sans ajouter également du hafnium et quand même améliorer la tenue à l'oxydation à chaud du superalliage.

Par ailleurs, l'addition de chrome ou d'aluminium permet d'améliorer la résistance à l'oxydation et à la corrosion à haute température du superalliage. En particulier, le chrome est essentiel pour augmenter la résistance à la corrosion à chaud des superalliages à base de nickel. Toutefois, une teneur trop élevée en chrome tend à réduire la température de solvus de la phase γ' du superalliage à base de nickel, c'est-à-dire la température au-dessus de laquelle la phase y' est totalement dissoute dans la matrice γ, ce qui est indésirable. Aussi, la concentration en chrome est comprise entre 6,0 à 7,0% en masse afin de conserver une température élevée de solvus de la phase y' du superalliage à base de nickel, par exemple supérieure ou égale à 1250°C mais également pour éviter la formation de phases topologiquement compactes dans la matrice γ fortement saturée en éléments d'alliages tels que rhénium, le molybdène ou le tungstène.

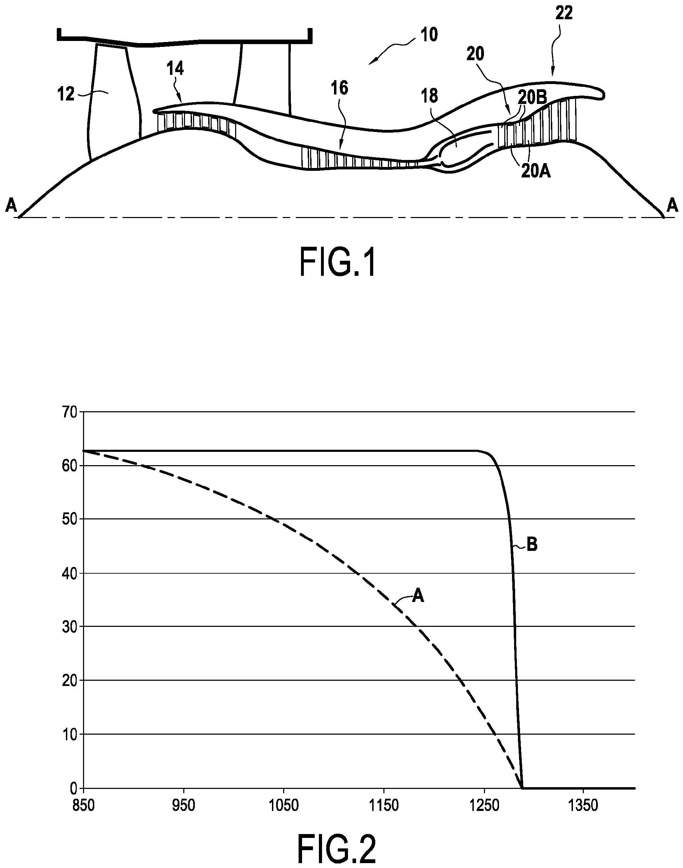

L'addition de platine permet d'augmenter la stabilité en température de la phase γ' en maintenant la fraction des précipités durcissant de phase γ' élevée par rapport aux alliages courants où cette fraction diminue significativement au cours de l'élévation de température. Ce maintien d'une forte proportion de précipités γ' à haute température permet un maintien des propriétés mécaniques de l'alliage à des températures proches de la température de solvus γ' de l'alliage (voir figure 2). De plus, l'addition de platine permet d'améliorer la résistance à l'oxydation et à la corrosion du superalliage. L'ajout de platine dans le superalliage permet ainsi d'améliorer la durée de vie du système comprenant un superalliage recouvert d'un revêtement métallique et d'une barrière thermique. Dans le cas de l'utilisation d'un superalliage avec un revêtement métallique de type NixPtyAlz, l'ajout de platine à la composition chimique du superalliage permet de diminuer, ou supprimer, l'ajout de platine dans le revêtement.

L'addition de cobalt, qui est un élément proche du nickel et qui se substitue partiellement au nickel, forme une solution solide avec le nickel dans la matrice γ. Le cobalt permet de renforcer la matrice γ, de réduire la sensibilité à la précipitation de PTC et à la formation de ZRS dans le superalliage sous le revêtement de protection. Cependant, une teneur trop élevée en cobalt tend à réduire la température de solvus de la phase γ' du superalliage à base de nickel, ce qui est indésirable.

L'addition de molybdène, de tungstène, de rhénium ou de tantale, qui sont des éléments réfractaires, permet de ralentir les mécanismes contrôlant le fluage des superalliages à base de nickel et qui dépendent de la diffusion des éléments chimiques dans le superalliage.

Une teneur très basse en soufre dans un superalliage à base de nickel permet d'augmenter la résistance à l'oxydation et à la corrosion à chaud ainsi que la tenue à l'écaillage de la barrière thermique. Ainsi, une faible teneur en soufre, inférieure à 2 ppm en masse (partie par million en masse), voire idéalement inférieure à 0,5 ppm en masse, permet d'optimiser ces propriétés. Une telle teneur massique en soufre peut être obtenue par élaboration d'une coulée mère à bas soufre ou par un procédé de désulfuration réalisé après la coulée. Il est notamment possible de maintenir un bas taux de soufre en adaptant le procédé d'élaboration du superalliage.

On entend par superalliages à base de nickel, des superalliages dont le pourcentage massique en nickel est majoritaire. On comprend que le nickel est donc l'élément dont le pourcentage massique dans l'alliage est le plus élevé.

Le superalliage peut comprendre, en pourcentages massiques, 5,0 à 6,0 % d'aluminium, 6,0 à 9,5 % de tantale, 0 à 1,50 % de titane, 8,0 à 10,0 % de cobalt, 6,0 à 7,0 % de chrome, 0,30 à 0,90 % de molybdène, 5,5 à 6,5 % de tungstène, 0 à 2,50 % de rhénium, 0,05 à 0,15 % de hafnium, 1,70 à 4,30 % de platine, 0 à 0,15 % de silicium, le complément étant constitué par du nickel et des impuretés inévitables.

Le superalliage peut comprendre, en pourcentages massiques, 5,0 à 6,0 % d'aluminium, 6,0 à 7,0 % de tantale, 0 à 1,50 % de titane, 8,0 à 10,0 % de cobalt, 6,0 à 7,0 % de chrome, 0,30 à 0,90 % de molybdène, 5,5 à 6,5 % de tungstène, 0 à 2,50 % de rhénium, 0,05 à 0,15 % de hafnium, 1,70 à 4,30 % de platine, 0 à 0,15 % de silicium, le complément étant constitué par du nickel et des impuretés inévitables.

Le superalliage peut comprendre, en pourcentages massiques, 5,0 à 6,0 % d'aluminium, 8,5 à 9,5 % de tantale, 0 à 1,50 % de titane, 8,0 à 10,0 % de cobalt, 6,0 à 7,0 % de chrome, 0,30 à 0,90 % de molybdène, 5,5 à 6,5 % de tungstène, 0 à 1,50 % de rhénium, 0,05 à 0,15 % de hafnium, 1,70 à 3,30 % de platine, 0 à 0,15 % de silicium, le complément étant constitué par du nickel et des impuretés inévitables.

Le superalliage peut comprendre, en pourcentages massiques, 5,0 à 6,0 % d'aluminium, 6,0 à 9,5 % de tantale, 8,0 à 10,0 % de cobalt, 6,0 à 7,0 % de chrome, 0,30 à 0,90 % de molybdène, 5,5 à 6,5 % de tungstène, 0,05 à 0,15 % de hafnium, 2,70 à 4,30 % de platine, 0 à 0,15 % de silicium, le complément étant constitué par du nickel et des impuretés inévitables.

Le superalliage peut comprendre, en pourcentages massiques, 5,0 à 6,0 % d'aluminium, 6,0 à 9,5 % de tantale, 0,50 à 1,50 % de titane, 8,0 à 10,0 % de cobalt, 6,0 à 7,0 % de chrome, 0,30 à 0,90 % de molybdène, 5,5 à 6,5 % de tungstène, 0,05 à 0,15 % de hafnium, 2,70 à 4,30 % de platine, 0 à 0,15 % de silicium, le complément étant constitué par du nickel et des impuretés inévitables.

Le superalliage peut comprendre, en pourcentages massiques, 5,0 à 6,0 % d'aluminium, 6,0 à 9,5 % de tantale, 0,80 à 1,20 % de titane, 8,0 à 10,0 % de cobalt, 6,0 à 7,0 % de chrome, 0,30 à 0,90 % de molybdène, 5,5 à 6,5 % de tungstène, 0 à 2,50 % de rhénium, 0,05 à 0,15 % de hafnium, 0,70 à 3,30 % de platine, 0 à 0,15 % de silicium, le complément étant constitué par du nickel et des impuretés inévitables.

Le superalliage peut comprendre, en pourcentages massiques, 5,0 à 6,0 % d'aluminium, 6,0 à 9,5 % de tantale, 0 à 1,50 % de titane, 8,0 à 10,0 % de cobalt, 6,0 à 7,0 % de chrome, 0,30 à 0,90 % de molybdène, 5,5 à 6,5 % de tungstène, 0 à 2,50 % de rhénium, 0,05 à 0,15 % de hafnium, 0,70 à 4,30 % de platine, 0,10 % de silicium, le complément étant constitué par du nickel et des impuretés inévitables.

Le superalliage peut comprendre, en pourcentages massiques, 5,0 à 6,0 % d'aluminium, 6,0 à 7,0 % de tantale, 0,80 à 1,20 % de titane, 8,0 à 10,0 % de cobalt, 6,0 à 7,0 % de chrome, 0,30 à 0,90 % de molybdène, 5,5 à 6,5 % de tungstène, 0,05 à 0,15 % de hafnium, 2,70 à 3,30 % de platine, 0 à 0,15 % de silicium, le complément étant constitué par du nickel et des impuretés inévitables.

Le superalliage peut comprendre, en pourcentages massiques, 5,0 à 6,0 % d'aluminium, 6,0 à 7,0 % de tantale, 0,80 à 1,20 % de titane, 8,0 à 10,0 % de cobalt, 6,0 à 7,0 % de chrome, 0,30 à 0,90 % de molybdène, 5,5 à 6,5 % de tungstène, 0,70 à 1,30 % de rhénium, 0,05 à 0,15 % de hafnium, 1,70 à 2,30 % de platine, 0 à 0,15 % de silicium, le complément étant constitué par du nickel et des impuretés inévitables.

Le superalliage peut comprendre, en pourcentages massiques, 5,0 à 6,0 % d'aluminium, 6,0 à 7,0 % de tantale, 0,80 à 1,20 % de titane, 8,0 à 10,0 % de cobalt, 6,0 à 7,0 % de chrome, 0,30 à 0,90 % de molybdène, 5,5 à 6,5 % de tungstène, 1,70 à 2,30 % de rhénium, 0,05 à 0,15 % de hafnium, 0,70 à 1,30 % de platine, 0 à 0,15 % de silicium, le complément étant constitué par du nickel et des impuretés inévitables.

Le superalliage peut comprendre, en pourcentages massiques, 5,0 à 6,0 % d'aluminium, 6,0 à 7,0 % de tantale, 8,0 à 10,0 % de cobalt, 6,0 à 7,0 % de chrome, 0,30 à 0,90 % de molybdène, 5,5 à 6,5 % de tungstène, 0,05 à 0,15 % de hafnium, 3,70 à 4,30 % de platine, 0 à 0,15 % de silicium, le complément étant constitué par du nickel et des impuretés inévitables.

Le superalliage peut comprendre, en pourcentages massiques, 5,0 à 6,0 % d'aluminium, 8,5 à 9,5 % de tantale, 0,80 à 1,20 % de titane, 8,0 à 10,0 % de cobalt, 6,0 à 7,0 % de chrome, 0,30 à 0,90 % de molybdène, 5,5 à 6,5 % de tungstène, 0,70 à 2,30 % de rhénium, 0,05 à 0,15 % de hafnium, 1,70 à 2,30 % de platine, 0 à 0,15 % de silicium, le complément étant constitué par du nickel et des impuretés inévitables.

Le superalliage peut comprendre, en pourcentages massiques, 5,0 à 6,0 % d'aluminium, 8,5 à 9,5 % de tantale, 8,0 à 10,0 % de cobalt, 6,0 à 7,0 % de chrome, 0,30 à 0,90 % de molybdène, 5,5 à 6,5 % de tungstène, 0,05 à 0,15 % de hafnium, 2,70 à 3,30 % de platine, 0 à 0,15 % de silicium, le complément étant constitué par du nickel et des impuretés inévitables.

Le superalliage peut comprendre, en pourcentages massiques, 5,0 à 6,0 % d'aluminium, 8,5 à 9,5 % de tantale, 0,80 à 1,20 % de titane, 8,0 à 10,0 % de cobalt, 6,0 à 7,0 % de chrome, 0,30 à 0,90 % de molybdène, 5,5 à 6,5 % de tungstène, 0,05 à 0,15 % de hafnium, 2,70 à 3,30 % de platine, 0,10 % de silicium, le complément étant constitué par du nickel et des impuretés inévitables.

Le superalliage peut comprendre, en pourcentages massiques, 5,6 % d'aluminium, 6,5 % de tantale, 1,00 % de titane, 9,0 % de cobalt, 6,5 % de chrome, 0,60 % de molybdène, 6,0 % de tungstène, 0,10 % de hafnium, 3,00 % de platine, le complément étant constitué par du nickel et des impuretés inévitables.

Le superalliage peut comprendre, en pourcentages massiques, 5,6 % d'aluminium, 6,5 % de tantale, 1,00 % de titane, 9,0 % de cobalt, 6,5 % de chrome, 0,60 % de molybdène, 6,0 % de tungstène, 1,00 % de rhénium, 0,10 % de hafnium, 2,00 % de platine, le complément étant constitué par du nickel et des impuretés inévitables.

Le superalliage peut comprendre, en pourcentages massiques, 5,6 % d'aluminium, 6,5 % de tantale, 1,00 % de titane, 9,0 % de cobalt, 6,5 % de chrome, 0,60 % de molybdène, 6,0 % de tungstène, 2,00 % de rhénium, 0,10 % de hafnium, 1,00 % de platine, le complément étant constitué par du nickel et des impuretés inévitables.

Le superalliage peut comprendre, en pourcentages massiques, 5,6 % d'aluminium, 6,5 % de tantale, 9,0 % de cobalt, 6,5 % de chrome, 0,60 % de molybdène, 6,0 % de tungstène, 0,10 % de hafnium, 4,00 % de platine, le complément étant constitué par du nickel et des impuretés inévitables.

Le superalliage peut comprendre, en pourcentages massiques, 5,6 % d'aluminium, 9,0 % de tantale, 1,00 % de titane, 9,0 % de cobalt, 6,5 % de chrome, 0,60 % de molybdène, 6,0 % de tungstène, 1,00 % de rhénium, 0,10 % de hafnium, 2,00 % de platine, le complément étant constitué par du nickel et des impuretés inévitables.

Le superalliage peut comprendre, en pourcentages massiques, 5,6 % d'aluminium, 9,0 % de tantale, 9,0 % de cobalt, 6,5 % de chrome, 0,60 % de molybdène, 6,0 % de tungstène, 0,10 % de hafnium, 3,00 % de platine, le complément étant constitué par du nickel et des impuretés inévitables.

Le superalliage peut comprendre, en pourcentages massiques, 5,6 % d'aluminium, 6,5 % de tantale, 1,00 % de titane, 9,0 % de cobalt, 6,5 % de chrome, 0,60 % de molybdène, 6,0 % de tungstène, 1,00 % de rhénium, 0,10 % de hafnium, 2,00 % de platine, le complément étant constitué par du nickel et des impuretés inévitables.

Le superalliage peut comprendre, en pourcentages massiques, 5,6 % d'aluminium, 9,0 % de tantale, 1,00 % de titane, 9,0 % de cobalt, 6,5 % de chrome, 0,60 % de molybdène, 6,0 % de tungstène, 0,10 % de hafnium, 3,00 % de platine, 0,10 % de silicium, le complément étant constitué par du nickel et des impuretés inévitables.

Le présent exposé concerne également une aube monocristalline pour turbomachine comprenant un superalliage tel que défini précédemment.

Cette aube présente donc une résistance au fluage à haute température améliorée. Cette aube présente donc une résistance à l'oxydation et à la corrosion améliorée.

L'aube peut comprendre un revêtement de protection comportant une sous-couche métallique déposée sur le superalliage et une barrière thermique céramique déposée sur la sous-couche métallique.

Grâce à la composition du superalliage à base de nickel, la formation d'une zone de réaction secondaire dans le superalliage résultant des phénomènes d'inter-diffusion entre le superalliage et la sous-couche est évitée, ou limitée.

La sous-couche métallique peut être un alliage de type MCrAlY ou un alliage de type aluminiure de nickel.

Grâce à la composition du superalliage à base de nickel, l'ajout de platine est réduit, voire supprimée, dans la sous-couche métallique du revêtement de type $Ni_xAl_yPt_z$.

La barrière thermique céramique peut être un matériau à base de zircone yttriée ou tout autre revêtement céramique (à base de zircone) à faible conductivité thermique.

L'aube peut présenter une structure orientée selon une direction cristallographique <001>.

Cette orientation confère généralement les propriétés mécaniques optimales à l'aube.

Le présent exposé concerne aussi une turbomachine comprenant une aube telle que définie précédemment.

Brève description des dessins

D'autres caractéristiques et avantages de l'objet du présent exposé ressortiront de la description suivante de modes de réalisation, donnés à titre d'exemples non limitatifs, en référence aux figures annexées, sur lesquelles :

- la figure 1 est une vue schématique en coupe longitudinale d'une turbomachine ;
- la figure 2 est un graphique représentant l'évolution de la fraction volumique de phase $\gamma'$ en fonction de la température
- la figure 3 est un graphique représentant le paramètre NFP (No-Freckles Parameter) pour différents superalliages ;
- la figure 4 est un graphique représentant la fraction volumique de phase $\gamma'$ à différentes températures et pour différents superalliages ;
- la figure 5 est un graphique représentant la limite d'élasticité à 0,2 % en fonction de la température pour deux superalliages ;
- la figure 6 est un graphique représentant la résistance à la rupture en fonction de la température pour les deux superalliages de la figure 5 ;
- la figure 7 est un graphique représentant la prise de masse en fonction du temps à 1000°C pour trois superalliages ;
- la figure 8 est une micrographie présentant la microstructure d'un superalliage.

Sur l'ensemble des figures, les éléments en commun sont repérés par des références numériques identiques.

Description détaillée

Les superalliages à base de nickel sont destinés à la fabrication d'aubes monocristallines par un procédé de solidification dirigée dans un gradient thermique. L'utilisation d'un germe monocristallin ou d'un sélecteur de grain en début de solidification permet d'obtenir cette structure monocristalline. La structure est orientée par exemple selon une direction cristallographique <001> qui est l'orientation qui confère, en général, les propriétés mécaniques optimales aux superalliages.

Les superalliages monocristallins à base de nickel bruts de solidification ont une structure dendritique et sont constitués de précipités $\gamma'$ $Ni_3(Al, Ti, Ta)$ dispersés dans une matrice $\gamma$ de structure cubique à faces centrées, solution solide à base de nickel. Ces précipités de phase $\gamma'$ sont répartis de façon hétérogène dans le volume du monocristal du fait de ségrégations chimiques résultant du procédé de solidification. Par ailleurs, des phases eutectiques $\gamma/\gamma'$ sont présentes dans les régions inter-dendritiques et constituent des sites préférentiels d'amorçage de fissures. Ces phases eutectiques $\gamma/\gamma'$ se forment en fin de solidification. De plus, les phases eutectiques $\gamma/\gamma'$ sont formées au détriment des fins précipités (taille inférieure au micromètre) de phase durcissante $\gamma'$. Ces précipités de phase $\gamma'$ constituent la principale source de durcissement des superalliages à base de nickel. Aussi, la présence de phases eutectiques $\gamma/\gamma'$ résiduelles ne permet pas d'optimiser la tenue au fluage à chaud du superalliage à base de nickel.

Il a en effet été montré que les propriétés mécaniques des superalliages, en particulier la résistance au fluage, étaient optimales lorsque la précipitation des précipités $\gamma'$ était ordonnée, c'est-à-dire que les précipités de phase $\gamma'$ sont alignés de manière régulière, avec une taille allant de 300 à 500 nm, et lorsque la totalité des phases eutectiques $\gamma/\gamma'$ était remise en solution.

Les superalliages à base de nickel bruts de solidification sont donc traités thermiquement pour obtenir la répartition désirée des différentes phases. Le premier traitement thermique est un traitement d'homogénéisation de la microstructure qui a pour objectif de dissoudre les précipités de phase $\gamma'$ et d'éliminer les phases eutectiques $\gamma/\gamma'$ ou de réduire de manière significative leur fraction volumique. Ce traitement est réalisé à une température supérieure à la température de solvus de la phase $\gamma'$ et inférieure à la température de fusion commençante du superalliage ($T_{solidus}$). Une trempe est ensuite réalisée à la fin de ce premier traitement thermique pour obtenir une dispersion fine et homogène des précipités $\gamma'$. Des traitements thermiques de revenu sont ensuite réalisés en deux étapes, à des températures inférieures à la température de solvus de la phase $\gamma'$. Lors d'une première étape, pour faire grossir les précipités $\gamma'$ et obtenir la taille désirée, puis lors d'une seconde étape, pour faire croître la fraction volumique de cette phase jusqu'à environ 70% à température ambiante.

La figure 1 représente, en coupe selon un plan vertical passant par son axe principal A, un turboréacteur à double flux 10. Le turboréacteur à double flux 10 comporte, d'amont en aval selon la circulation du flux d'air, une soufflante 12, un compresseur basse pression 14, un compresseur haute pression 16, une chambre de combustion 18, une turbine haute pression 20, et une turbine basse pression 22.

La turbine haute pression 20 comprend une pluralité d'aubes mobiles 20A tournant avec le rotor et de redresseurs 20B (aubes fixes) montés sur le stator. Le stator de la turbine 20 comprend une pluralité d'anneaux 24 de stator disposés en vis-à-vis des aubes mobiles 20A de la turbine 20.

Ces propriétés font ainsi de ces superalliages des candidats intéressants pour la fabrication de pièces monocristallines destinées aux parties chaudes des turboréacteurs.

On peut donc fabriquer une aube mobile 20A ou un redresseur 20B pour turbomachine comprenant un superalliage tel que défini précédemment.

On peut également fabriquer une aube mobile 20A ou un redresseur 20B pour turbomachine comprenant un superalliage tel que défini(e) précédemment revêtu(e) d'un revêtement de protection comprenant une sous-couche métallique

Une turbomachine peut notamment être un turboréacteur tel qu'un turboréacteur à double flux 10. La turbomachine peut également être un turboréacteur à simple flux, un turbopropulseur ou un turbomoteur.

Exemples

Huit superalliages monocristallins à base de nickel du présent exposé (Ex 1 à Ex 8) ont été étudiés et comparés à cinq superalliages monocristallins commerciaux : René N5 (Ex 9), CMSX-4 (Ex 10), CMSX-4 Plus Mod C (Ex 11), René N6 (Ex 12), CMSX-10 K (Ex 13) et un superalliage expérimental comportant du platine (Ex 14), cité dans la publication J. S. Van Sluytman, C. J. Moceri, and T. M. Pollock, "A Pt-modified Ni-base superalloy with high temperature precipitate stability," Mater. Sci. Eng. A, vol. 639, pp. 747-754, Jul. 2015. La composition chimique de chacun des superalliages monocristallins est donnée dans le tableau 1, la composition Ex 7 comportant de plus 0,03 % en masse de carbone, la composition Ex 13 comportant de plus 0,10 % en masse de niobium (Nb), la composition Ex 12 comportant en outre 0,05 % en masse de carbone (C) et 0,004 % en masse de bore (B) et la composition Ex 14 comprenant de plus 0,02 % en masse de carbone, 0,015 % en masse de bore et 0,02 % en masse de zircon. Tous ces superalliages sont des superalliages à base de nickel, c'est-à-dire que le complément à 100 % des compositions présentées est constitué par du nickel et des impuretés inévitables.

Les superalliages Ex 1 à Ex 8 présentent une évolution de la fraction volumique de la phase $\gamma'$ en fonction de la température selon la courbe B de la figure 2 alors que les superalliages Ex 9 à Ex 14 présentent une évolution de la fraction volumique de la phase $\gamma'$ en fonction de la température selon la courbe A de la figure 2.

Tableau 1

|  | Al | Ta | Ti | Co | Cr | Mo | W | Re | Hf | Pt | Si |
|---|---|---|---|---|---|---|---|---|---|---|---|
| Ex 1 | 5,6 | 6,5 | 1,00 | 9,0 | 6,5 | 0,60 | 6,0 | 0 | 0,10 | 3,00 | 0 |

(suite)

|  | Al | Ta | Ti | Co | Cr | Mo | W | Re | Hf | Pt | Si |
|---|---|---|---|---|---|---|---|---|---|---|---|
| Ex 2 | 5,6 | 6,5 | 1,00 | 9,0 | 6,5 | 0,60 | 6,0 | 1,00 | 0,10 | 2,00 | 0 |
| Ex 3 | 5,6 | 6,5 | 1,00 | 9,0 | 6,5 | 0,60 | 6,0 | 2,00 | 0,10 | 1,00 | 0 |
| Ex 4 | 5,6 | 6,5 | 0 | 9,0 | 6,5 | 0,60 | 6,0 | 0 | 0,10 | 4,00 | 0 |
| Ex 5 | 5,6 | 9,0 | 1,00 | 9,0 | 6,5 | 0,60 | 6,0 | 1,00 | 0,10 | 2,00 | 0 |
| Ex 6 | 5,6 | 9,0 | 0 | 9,0 | 6,5 | 0,60 | 6,0 | 0 | 0,10 | 3,00 | 0 |
| Ex 7 | 5,6 | 6,5 | 1,00 | 9,0 | 6,5 | 0,60 | 6,0 | 1,00 | 0,10 | 2,00 | 0 |
| Ex 8 | 5,6 | 9,0 | 1,00 | 9,0 | 6,5 | 0,60 | 6,0 | 0 | 0,10 | 3,00 | 0,01 |
| Ex 9 | 6,2 | 6,0 | 0 | 8,0 | 7,0 | 2,00 | 5,0 | 3,00 | 0,20 | 0 | 0 |
| Ex 10 | 5,6 | 6,5 | 1,00 | 9,0 | 6,5 | 0,60 | 6,0 | 3,00 | 0,10 | 0 | 0 |
| Ex 11 | 5,7 | 8,0 | 0,85 | 10,0 | 3,50 | 0,60 | 6,0 | 4,40 | 0,10 | 0 | 0 |
| Ex 12 | 6,0 | 7,5 | 0 | 12,2 | 4,40 | 1,10 | 5,7 | 5,3 | 0,15 | 0 | 0 |
| Ex 13 | 5,7 | 8,0 | 0,20 | 3,00 | 2,00 | 0,40 | 5,0 | 6,0 | 0,03 | 0 | 0 |
| Ex 14 | 5,8 | 5,8 | 0,40 | 0 | 6,2 | 1,50 | 2,90 | 3,00 | 0,30 | 7,8 | 0,20 |

Masse volumique

La masse volumique à température ambiante de chaque superalliage a été estimée à l'aide d'une version modifiée de la formule de Hull (F.C. Hull, Metal Progress, Novembre 1969, pp139-140). La masse volumique est exprimée en g.cm$^{-3}$ (gramme par centimètre cube). Cette équation empirique a été proposée par Hull. L'équation empirique est basée sur la loi des mélanges et comprend des termes correctifs déduits d'une analyse par régression linéaire de données expérimentales (compositions chimiques et masses volumiques mesurées) concernant 235 superalliages et aciers inox. Cette formule de Hull a été modifiée, notamment pour tenir compte d'éléments comme le rhénium et le ruthénium. La formule de Hull modifiée donnée par P. Carondans « High gamma prime solvus New Generation Nickel-Based Superalloys for Single Crystal turbine Balde Applications », 2000, pp737-746 est la suivante :

$$(1) \quad d = 8,29604 - 0,00435 \, wt\%Co - 0,0164 \, wt\%(Cr+Mo) +$$
$$0,06274 \, wt\%W + 0,0593 \, wt\%(Re+Pt) + 0,01811 \, wt\%Ru -$$
$$0,06595 \, wt\%Al - 0,0236 \, wt\%Ti + 0,05441 \, wt\%Ta$$

où wt%Co, wt%(Cr+Mo), ..., wt%Ta sont les pourcentages massiques des éléments Co, (Cr+Mo), ..., Ta.
où d est la masse volumique du superalliage exprimé en g/cm$^3$.

Par exemple, la masse volumique du superalliage Ex 5 est estimée à 8,81 g/cm$^3$ et la valeur mesurée est de 8,83 g/cm$^3$. La masse volumique mesurée est mesurée au pycnomètre à hélium. On constate donc une bonne adéquation de la formule de Hull modifiée ci-dessus avec la masse volumique mesurée des superalliages.
Les masses volumiques calculées pour les alliages de l'invention et pour les alliages de référence sont inférieures à 8,90 g/cm$^3$, de préférence inférieure à 8,85 g/cm$^3$ (voir Tableau 2).
Le tableau 2 présente différents paramètres pour les superalliages Ex 1 à Ex 12.

Tableau 2

|  | Masse volumique estimée (1) (g/cm$^3$) | NFP | [ZRS(%)]$^{1/2}$ | Coût (euros/kg) | δ' à 25°C (%) | δ' à 1100° C (%) |
|---|---|---|---|---|---|---|
| Ex 1 | 8,67 | 1,08 | -29,91 | 1019,28 | 0,248 | -0,065 |
| Ex 2 | 8,67 | 0,90 | -25,72 | 721,98 | 0,250 | -0,136 |
| Ex 3 | 8,67 | 0,77 | -21,54 | 424,68 | 0,274 | -0,207 |

(suite)

| | Masse volumique estimée (1) (g/cm³) | NFP | [ZRS(%)]^{1/2} | Coût (euros/kg) | $\delta'$ à 25°C (%) | $\delta'$ à 1100° C (%) |
|---|---|---|---|---|---|---|
| Ex 4 | 8,76 | 1,16 | -29,61 | 1329,38 | 0,363 | 0,047 |
| Ex 5 | 8,81 | 1,24 | -26,05 | 724,84 | 0,257 | -0,205 |
| Ex 6 | 8,83 | 1,58 | -30,36 | 1012,07 | 0,313 | -0,007 |
| Ex 7 | 8,67 | 0,90 | -25,72 | 721,98 | 0,251 | -0,130 |
| Ex 8 | 8,81 | 1,49 | -30,30 | 1022,14 | 0,152 | -0,141 |
| Ex 9 | 8,58 | 0,85 | -21,95 | 118,34 | 0,182 | -0,274 |
| Ex 10 | 8,67 | 0,67 | -17,36 | 127,38 | 0,279 | -0,222 |
| Ex 11 | 8,90 | 0,68 | 3,70 | 160,20 | 0,363 | 0,005 |
| Ex 12 | 8,87 | 0,69 | 1,35 | 167,13 | 0,331 | -0,205 |
| Ex 13 | 8,98 | 0,67 | 15,56 | 170,94 | 0,256 | -0,185 |
| Ex 14 | 8,96 | 1,05 | -15,64 | 2612,21 | 0,262 | -0,134 |

No-Freckles Parameter (NFP)

$$(2) \quad NFP = [\%Ta + 1,5\ \%Hf + 0,5\ \%Mo - 0,5\%\ \%Ti)]/[\%W + 1,2\ \%Re)]$$

où %Cr, %Ni, ...%X sont les teneurs, exprimées en pourcentages massiques, des éléments du superalliage Cr, Ni, ..., X.

Le paramètre NFP permet de quantifier la sensibilité à la formation de grains parasites de type « Freckles » au cours de la solidification dirigée de la pièce (document US 5,888,451). Pour éviter la formation de défauts de type « Freckles », le paramètre NFP doit être supérieur ou égal à 0,7.

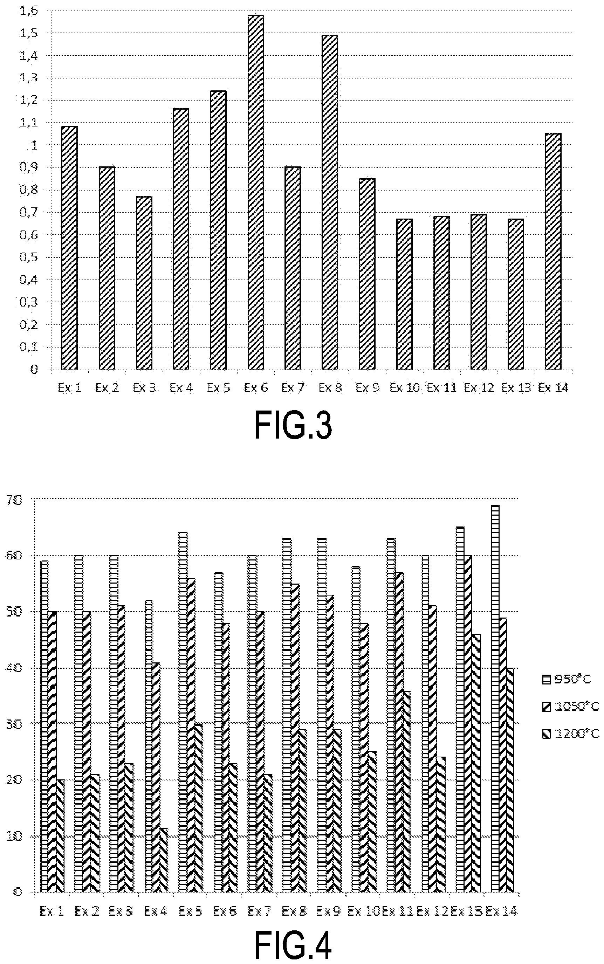

Comme on peut le voir dans le tableau 2 et sur la figure 3, les superalliages Ex 1 à Ex 8 présentent tous un paramètre NFP supérieur ou égal à 0,7 alors que les superalliages commerciaux Ex 10 à Ex 13 présentent un paramètre NFP inférieur à 0,7.

Sensibilité à la formation de ZRS

Pour estimer la sensibilité de superalliages à base de nickel contenant du rhénium à la formation de ZRS, Walston (document US 5,270,123) a établi l'équation suivante :

$$(3) \quad [ZRS(\%)]^{1/2} = 13,88\ (\%Re) + 4,10\ (\%W) - 7,07\ (\%Cr) - 2,94\ (\%Mo) - 0,33\ (\%Co) + 12,13$$

où ZRS(%) est le pourcentage linéique de ZRS dans le superalliage sous le revêtement et où les concentrations des éléments d'alliage sont en pourcentages atomiques.

Cette équation (3) a été obtenue par analyse par régression linéaire multiple à partir d'observations faites après vieillissement de 400 heures à 1093°C (degré centigrade) d'échantillons de divers alliages de compositions proches de la composition Ex 12 sous un revêtement NiPtAl.

Plus la valeur du paramètre $[ZRS(\%)]^{1/2}$ est élevée, plus le superalliage est sensible à la formation de ZRS. Ainsi, comme on peut le voir dans le tableau 2, pour les superalliages Ex 1 à Ex 8, les valeurs du paramètre $[ZRS(\%)]^{1/2}$ sont toutes négatives et ces superalliages présentent donc une faible sensibilité à la formation de ZRS sous un revêtement NitPtAl, tout comme le superalliage commercial Ex 12 qui est connu pour sa faible sensibilité à la formation de ZRS et les superalliages Ex 9, Ex 10 et Ex 14. A titre d'exemple, le superalliage commercial Ex 13, qui est connu pour être très sensible à la formation de ZRS sous un révêtement NiPtAl, présente une valeur du paramètre $[ZRS(\%)]$

$^{1/2}$ relativement élevée.

Coût des alliages

Le coût au kilogramme des superalliages Ex 1 à Ex 14 est calculé sur base de la composition du superalliage et des coûts de chaque composé (mise à jour février 2018). Ce coût est donné à titre indicatif.

Ecart de paramètre cristallin δ'

L'écart de paramètre cristallin entre les phases γ et γ', aussi appelé « Mismatch » δ' est exprimé en pourcent. Ce paramètre varie en fonction de la température du fait des coefficients de dilatation thermique différents de ces deux phases. Il est considéré comme influant sur les propriétés mécaniques et en particulier en fluage. Lorsque δ' est négatif, voire faiblement positif, la stabilité de la microstructure à la température donnée est favorisée.

Température de solvus de la phase γ'

Le logiciel ThermoCalc (base de donnée Ni25) basé sur la méthode CALPHAD a été utilisé pour calculer la température de solvus de la phase γ' à l'équilibre.
Comme on peut le constater dans le tableau 3, les superalliages Ex 1 à Ex 8 présentent une température de solvus γ' similaire à celles des superalliages Ex 9 à Ex 14.

Température de solidus et de liquidus

Le logiciel ThermoCalc (base de donnée Ni25) basé sur la méthode CALPHAD a été utilisé pour calculer les températures de solidus et de liquidus des superalliages Ex 1 à Ex 14.

Fraction volumique de phase γ'

Le logiciel ThermoCalc (base de donnée Ni25) basé sur la méthode CALPHAD a été utilisé pour calculer la fraction volumique (en pourcentage volumique) de phase γ' à l'équilibre dans les superalliages Ex 1 à Ex 14 à 950°C, 1050°C et 1200°C.
Comme on peut le constater dans le tableau 3 et sur la figure 4, les superalliages Ex 1 à Ex 8 contiennent des fractions volumiques de phase γ' supérieures ou comparables aux fractions volumiques de phase γ' des superalliages commerciaux Ex 9 à Ex 14.
Ainsi, la combinaison d'une température de solvus γ' élevée et de fractions volumiques de phase γ' élevées pour les superalliages Ex 1 à Ex 8 est favorable à une bonne résistance au fluage à haute température et très haute température, par exemple à 1200°C. Cette résistance doit être ainsi supérieure à la résistance au fluage des superalliages commerciaux Ex 9 à Ex 12 et proche de celle du superalliage commercial Ex 11.

Tableau 3

|  | Température de transformation (°C) | | | Fraction volumique de phase γ' (% vol) | | |
|---|---|---|---|---|---|---|
|  | Solvus | Solidus | Liquidus | 950°C | 1050°C | 1200°C |
| Ex 1 | 1262 | 1317 | 1380 | 59 | 50 | 20 |
| Ex 2 | 1266 | 1316 | 1383 | 60 | 50 | 21 |
| Ex 3 | 1271 | 1315 | 1385 | 60 | 51 | 23 |
| Ex 4 | 1244 | 1354 | 1398 | 52 | 41 | 11.5 |
| Ex 5 | 1294 | 1292 | 1366 | 64 | 56 | 30 |
| Ex 6 | 1284 | 1337 | 1386 | 57 | 48 | 23 |
| Ex 7 | 1266 | 1316 | 1383 | 60 | 50 | 21 |
| Ex 8 | 1292 | 1292 | 1365 | 63 | 55 | 29 |
| Ex 9 | 1306 | 1300 | 1392 | 63 | 53 | 29 |
| Ex 10 | 1270 | 1310 | 1385 | 58 | 48 | 25 |

(suite)

| | Température de transformation (°C) | | | Fraction volumique de phase $\gamma'$ (% vol) | | |
|---|---|---|---|---|---|---|
| | Solvus | Solidus | Liquidus | 950°C | 1050°C | 1200°C |
| Ex 11 | 1320 | 1330 | 1400 | 63 | 57 | 36 |
| Ex 12 | 1283 | 1319 | 1404 | 60 | 51 | 24 |
| Ex 13 | 1373 | 1381 | 1428 | 65 | 60 | 46 |
| Ex 14 | 1337 | 1343 | 1386 | 69 | 49 | 40 |

Fraction volumique de PTC de type $\sigma$

Le logiciel ThermoCalc (base de donnée nickel) basé sur la méthode CALPHAD a été utilisé pour calculer la fraction volumique (en pourcentage volumique) de phase $\sigma$ à l'équilibre dans les superalliages Ex 1 à Ex 14 à 950°C et 1050°C (voir tableau 4).

Les fractions volumiques calculées de phase $\sigma$ sont relativement faibles, ce qui traduit une faible sensibilité à la précipitation de PTC.

Concentration massique de chrome dissous dans la matrice $\gamma$

Le logiciel ThermoCalc (base de donnée Ni25) basé sur la méthode CALPHAD a été utilisé pour calculer teneur en chrome (en pourcentage massique) dans la phase $\gamma$ à l'équilibre dans les superalliages Ex 1 à Ex 14 à 950°C 1200°C.

Comme on peut le constater dans le tableau 4, les concentrations en chrome dans la phase $\gamma$ sont supérieures ou similaires pour les superalliages Ex 1 à Ex 8, comparées aux concentrations en chrome dans la phase $\gamma$ pour les superalliages commerciaux Ex 9 à Ex 13, ce qui est favorable à une meilleure résistance à la corrosion et à l'oxydation à chaud.

Tableau 4

| | Fraction volumique de PTC de type $\sigma$ (en % vol) | | Teneur en chrome dans la phase $\gamma$ (en % massique) | |
|---|---|---|---|---|
| | 950°C | 1050°C | 950°C | 1200°C |
| Ex 1 | 0 | 0 | 12,3 | 7,5 |
| Ex 2 | 0 | 0 | 12,4 | 7,6 |
| Ex 3 | 0 | 0 | 12,5 | 7,7 |
| Ex 4 | 0 | 0 | 10,7 | 7,0 |
| Ex 5 | 0 | 0 | 14,0 | 8,3 |
| Ex 6 | 0 | 0 | 12,1 | 7,7 |
| Ex 7 | 0 | 0 | 12,4 | 7,6 |
| Ex 8 | 0 | 0 | 13,9 | 8,2 |
| Ex 9 | 0,3 | 0 | 13,3 | 8,6 |
| Ex 10 | 0,7 | 0 | 10,9 | 7,8 |
| Ex 11 | 1,2 | 0,5 | 6,4 | 4,8 |
| Ex 12 | 1,0 | 0,3 | 7,1 | 5,3 |
| Ex 13 | 0,9 | 0,4 | 3,4 | 2,8 |
| Ex 14 | 0,07 | 0 | 12,1 | 8,4 |

Propriétés mécaniques

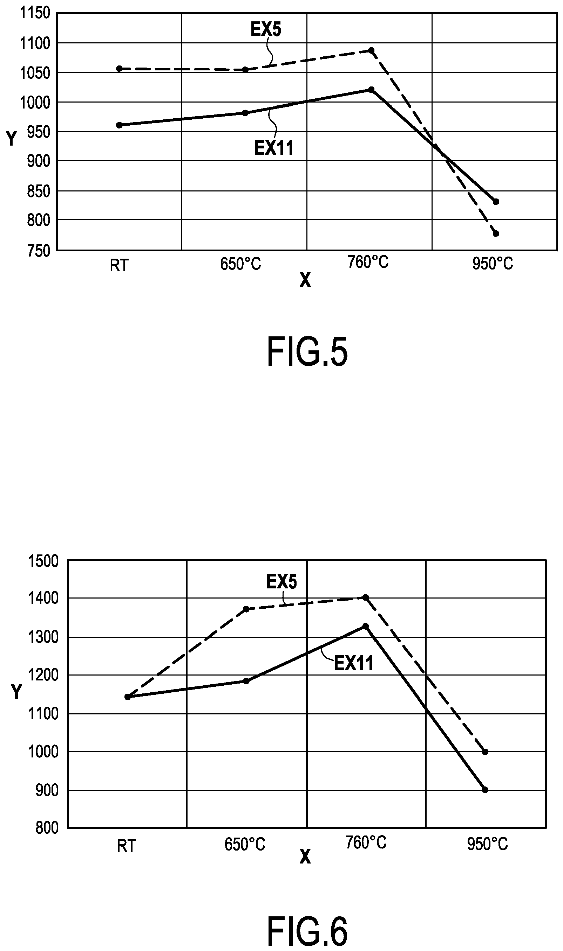

La figure 5 représente l'évolution de la limite d'élasticité à 0,2 % (en MPa) en fonction de la température (en °C) pour le superalliage Ex 5 et le superalliage Ex 11 à 650°C, 760°C et 950°C.

La figure 6 représente l'évolution de la résistance à la rupture en traction (en MPa) en fonction de la température (en °C) pour le superalliage Ex 5 et le superalliage Ex 11 à 650°C, 760°C et 950°C.

La limite d'élasticité à 0,2 % et la résistance à la rupture sont mesurées selon les normes ISO 6892-1 à température ambiante et ISO 6892-2 pour les températures supérieures à la température ambiante.

Comme on peut le constater sur la figure 5, le superalliage Ex 5 présente une limite d'élasticité à 0,2 % et une résistance à la rupture similaire à celle du superalliage Ex 11.

Propriété en oxydation

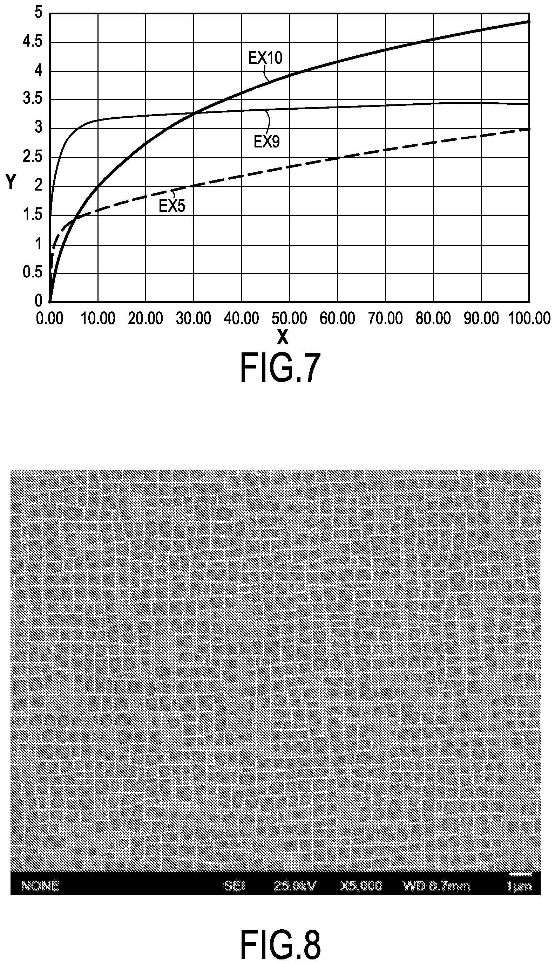

Les propriétés en oxydation des superalliages Ex 5, Ex 9 et Ex 10 sont illustrées sur la figure 7. On a mesuré la prise de masse (en $g/m^2$) en fonction du temps (en heure) des superalliages à 1000°C. Comme représenté sur la figure 7, on constate que le superalliage Ex 5 présente une prise en masse inférieure aux superalliages Ex 9 et Ex 10 après moins de 10 heures d'essai à 1000°C.

L'essai est réalisé sur des pastilles du matériau étudié de diamètre 14 mm et d'épaisseur 1,2 à 1,4 mm. L'essai d'oxydation, aussi appelé essai d'analyse thermogravimétrique, est réalisé sous flux constant d'air synthétique (21% $O_2$ + 79% $N_2$), avec une thermobalance compensée de la variation de poussée d'Archimède. Ainsi, la prise de masse est mesurée en continu, à la température de l'essai. A noter que les portes échantillons ont été préalablement stabilisés pour qu'ils ne réagissent pas avec les échantillons et qu'ils ne s'oxydent pas.

Microstructure

La figure 8 montre une microstructure du superalliage Ex 5 après mise en solution et revenu réalisée par microscopie électronique à balayage avec un grossissement de 5000 X. La microstructure représentée est typique d'une microstructure optimale pour les propriétés mécaniques des superalliages à base de nickel, présentant une microstructure avec des phases $\gamma/\gamma'$. Sur la figure 8, les précipités $\gamma'$ sont les cubes gris foncé.

Quoique le présent exposé ait été décrit en se référant à un exemple de réalisation spécifique, il est évident que des différentes modifications et changements peuvent être effectués sur ces exemples sans sortir de la portée générale de l'invention telle que définie par les revendications. En outre, des caractéristiques individuelles des différents modes de réalisation évoqués peuvent être combinées dans des modes de réalisation additionnels. Par conséquent, la description et les dessins doivent être considérés dans un sens illustratif plutôt que restrictif.

**Revendications**

1. Superalliage à base de nickel comprenant, en pourcentages massiques, 5,0 à 6,0 % d'aluminium, 6,0 à 9,5 % de tantale, 0 à 1,50 % de titane, 8,0 à 10,0 % de cobalt, 6,0 à 7,0 % de chrome, 0,30 à 0,90 % de molybdène, 5,5 à 6,5 % de tungstène, 0 à 2,50 % de rhénium, 0,05 à 0,15 % de hafnium, 0,70 à 4,30 % de platine, 0 à 0,15 % de silicium, le complément étant constitué par du nickel et des impuretés inévitables.

2. Superalliage selon la revendication 1, comprenant, en pourcentages massiques, 5,0 à 6,0 % d'aluminium, 6,0 à 9,5 % de tantale, 0 à 1,50 % de titane, 8,0 à 10,0 % de cobalt, 6,0 à 7,0 % de chrome, 0,30 à 0,90 % de molybdène, 5,5 à 6,5 % de tungstène, 0 à 2,50 % de rhénium, 0,05 à 0,15 % de hafnium, 1,70 à 4,30 % de platine, 0 à 0,15 % de silicium, le complément étant constitué par du nickel et des impuretés inévitables.

3. Superalliage selon la revendication 1, comprenant, en pourcentages massiques, 5,0 à 6,0 % d'aluminium, 6,0 à 7,0 % de tantale, 0 à 1,50 % de titane, 8,0 à 10,0 % de cobalt, 6,0 à 7,0 % de chrome, 0,30 à 0,90 % de molybdène, 5,5 à 6,5 % de tungstène, 0 à 2,50 % de rhénium, 0,05 à 0,15 % de hafnium, 1,70 à 4,30 % de platine, 0 à 0,15 % de silicium, le complément étant constitué par du nickel et des impuretés inévitables.

4. Superalliage selon la revendication 1, comprenant, en pourcentages massiques, 5,0 à 6,0 % d'aluminium, 8,5 à 9,5 % de tantale, 0 à 1,50 % de titane, 8,0 à 10,0 % de cobalt, 6,0 à 7,0 % de chrome, 0,30 à 0,90 % de molybdène, 5,5 à 6,5 % de tungstène, 0 à 1,50 % de rhénium, 0,05 à 0,15 % de hafnium, 1,70 à 3,30 % de platine, 0 à 0,15 % de silicium, le complément étant constitué par du nickel et des impuretés inévitables.

5. Superalliage selon la revendication 1, comprenant, en pourcentages massiques, 5,0 à 6,0 % d'aluminium, 6,0 à 9,5 % de tantale, 8,0 à 10,0 % de cobalt, 6,0 à 7,0 % de chrome, 0,30 à 0,90 % de molybdène, 5,5 à 6,5 % de tungstène, 0,05 à 0,15 % de hafnium, 2,70 à 4,30 % de platine, 0 à 0,15 % de silicium, le complément étant constitué par du nickel et des impuretés inévitables.

**6.** Superalliage selon la revendication 1, comprenant, en pourcentages massiques, 5,0 à. 6,0 % d'aluminium, 6,0 à 9,5 % de tantale, 0,50 à 1,50 % de titane, 8,0 à 10,0 % de cobalt, 6,0 à 7,0 % de chrome, 0,30 à 0,90 % de molybdène, 5,5 à 6,5 % de tungstène, 0,05 à 0,15 % de hafnium, 2,70 à 4,30 % de platine, 0 à 0,15 % de silicium, le complément étant constitué par du nickel et des impuretés inévitables.

**7.** Superalliage selon la revendication 1, comprenant, en pourcentages massiques, 5,0 à 6,0 % d'aluminium, 6,0 à 9,5 % de tantale, 0,80 à 1,20 % de titane, 8,0 à 10,0 % de cobalt, 6,0 à 7,0 % de chrome, 0,30 à 0,90 % de molybdène, 5,5 à 6,5 % de tungstène, 0 à 2,50 % de rhénium, 0,05 à 0,15 % de hafnium, 0,70 à 3,30 % de platine, 0 à 0,15 % de silicium, le complément étant constitué par du nickel et des impuretés inévitables.

**8.** Superalliage selon la revendication 1, comprenant, en pourcentages massiques, 5,0 à 6,0 % d'aluminium, 6,0 à 9,5 % de tantale, 0 à 1,50 % de titane, 8,0 à 10,0 % de cobalt, 6,0 à 7,0 % de chrome, 0,30 à 0,90 % de molybdène, 5,5 à 6,5 % de tungstène, 0 à 2,50 % de rhénium, 0,05 à 0,15 % de hafnium, 0,70 à 4,30 % de platine, 0,10 % de silicium, le complément étant constitué par du nickel et des impuretés inévitables.

**9.** Superalliage selon la revendication 1, comprenant, en pourcentages massiques, 5,0 à 6,0 % d'aluminium, 6,0 à 7,0 % de tantale, 0,80 à 1,20 % de titane, 8,0 à 10,0 % de cobalt, 6,0 à 7,0 % de chrome, 0,30 à 0,90 % de molybdène, 5,5 à 6,5 % de tungstène, 0,05 à 0,15 % de hafnium, 2,70 à 3,30 % de platine, 0 à 0,15 % de silicium, le complément étant constitué par du nickel et des impuretés inévitables.

**10.** Superalliage selon la revendication 1, comprenant, en pourcentages massiques, 5,0 à 6,0 % d'aluminium, 6,0 à 7,0 % de tantale, 0,80 à 1,20 % de titane, 8,0 à 10,0 % de cobalt, 6,0 à 7,0 % de chrome, 0,30 à 0,90 % de molybdène, 5,5 à 6,5 % de tungstène, 0,70 à 1,30 % de rhénium, 0,05 à 0,15 % de hafnium, 1,70 à 2,30 % de platine, 0 à 0,15 % de silicium, le complément étant constitué par du nickel et des impuretés inévitables.

**11.** Superalliage selon la revendication 1, comprenant, en pourcentages massiques, 5,0 à 6,0 % d'aluminium, 6,0 à 7,0 % de tantale, 0,80 à 1,20 % de titane, 8,0 à 10,0 % de cobalt, 6,0 à 7,0 % de chrome, 0,30 à 0,90 % de molybdène, 5,5 à 6,5 % de tungstène, 1,70 à 2,30 % de rhénium, 0,05 à 0,15 % de hafnium, 0,70 à 1,30 % de platine, 0 à 0,15 % de silicium, le complément étant constitué par du nickel et des impuretés inévitables.

**12.** Superalliage selon la revendication 1, comprenant, en pourcentages massiques, 5,0 à 6,0 % d'aluminium, 6,0 à 7,0 % de tantale, 8,0 à 10,0 % de cobalt, 6,0 à 7,0 % de chrome, 0,30 à 0,90 % de molybdène, 5,5 à 6,5 % de tungstène, 0,05 à 0,15 % de hafnium, 3,70 à 4,30 % de platine, 0 à 0,15 % de silicium, le complément étant constitué par du nickel et des impuretés inévitables.

**13.** Superalliage selon la revendication 1, comprenant, en pourcentages massiques, 5,0 à 6,0 % d'aluminium, 8,5 à 9,5 % de tantale, 0,80 à 1,20 % de titane, 8,0 à 10,0 % de cobalt, 6,0 à 7,0 % de chrome, 0,30 à 0,90 % de molybdène, 5,5 à 6,5 % de tungstène, 0,70 à 2,30 % de rhénium, 0,05 à 0,15 % de hafnium, 1,70 à 2,30 % de platine, 0 à 0,15 % de silicium, le complément étant constitué par du nickel et des impuretés inévitables.

**14.** Superalliage selon la revendication 1, comprenant, en pourcentages massiques, 5,0 à 6,0 % d'aluminium, 8,5 à 9,5 % de tantale, 8,0 à 10,0 % de cobalt, 6,0 à 7,0 % de chrome, 0,30 à 0,90 % de molybdène, 5,5 à 6,5 % de tungstène, 0,05 à 0,15 % de hafnium, 2,70 à 3,30 % de platine, 0 à 0,15 % de silicium, le complément étant constitué par du nickel et des impuretés inévitables.

**15.** Superalliage selon la revendication 1, comprenant, en pourcentages massiques, 5,0 à 6,0 % d'aluminium, 8,5 à 9,5 % de tantale, 0,80 à 1,20 % de titane, 8,0 à 10,0 % de cobalt, 6,0 à 7,0 % de chrome, 0,30 à 0,90 % de molybdène, 5,5 à 6,5 % de tungstène, 0,05 à 0,15 % de hafnium, 2,70 à 3,30 % de platine, 0,10 % de silicium, le complément étant constitué par du nickel et des impuretés inévitables.

**16.** Aube (20A, 20B) monocristalline pour turbomachine comprenant un superalliage selon l'une quelconque des revendications 1 à 15.

**17.** Aube (20A, 20B) selon la revendication 16, comprenant un revêtement de protection comportant une sous-couche métallique déposée sur le superalliage et une barrière thermique céramique déposée sur la sous-couche métallique.

**18.** Aube (20A, 20B) selon la revendication 16 ou 17, présentant une structure orientée selon une direction cristallographique <001>.

**19.** Turbomachine comprenant une aube (20A, 20B) selon l'une quelconque des revendications 16 à 18.

**Patentansprüche**

**1.** Superlegierung auf Nickelbasis, die, in Masseprozent, 5,0 bis 6,0 % Aluminium, 6,0 bis 9,5 % Tantal, 0 bis 1,50 % Titan, 8,0 bis 10,0 % Kobalt, 6,0 bis 7,0 % Chrom, 0,30 bis 0,90 % Molybdän, 5,5 bis 6,5 % Wolfram, 0 bis 2,50 % Rhenium, 0,05 bis 0,15 % Hafnium, 0,70 bis 4,30 % Platin, 0 bis 0,15 % Silizium umfasst, wobei der Rest aus Nickel und unvermeidlichen Verunreinigungen besteht.

**2.** Superlegierung nach Anspruch 1, die, in Masseprozent, 5,0 bis 6,0 % Aluminium, 6,0 bis 9,5 % Tantal, 0 bis 1,50 % Titan, 8,0 bis 10,0 % Kobalt, 6,0 bis 7,0 % Chrom, 0,30 bis 0,90 % Molybdän, 5,5 bis 6,5 % Wolfram, 0 bis 2,50 % Rhenium, 0,05 bis 0,15 % Hafnium, 1,70 bis 4,30 % Platin, 0 bis 0,15 % Silizium umfasst, wobei der Rest aus Nickel und unvermeidlichen Verunreinigungen besteht.

**3.** Superlegierung nach Anspruch 1, die, in Masseprozent, 5,0 bis 6,0 % Aluminium, 6,0 bis 7,0 % Tantal, 0 bis 1,50 % Titan, 8,0 bis 10,0 % Kobalt, 6,0 bis 7,0 % Chrom, 0,30 bis 0,90 % Molybdän, 5,5 bis 6,5 % Wolfram, 0 bis 2,50 % Rhenium, 0,05 bis 0,15 % Hafnium, 1,70 bis 4,30 % Platin, 0 bis 0,15 % Silizium umfasst, wobei der Rest aus Nickel und unvermeidlichen Verunreinigungen besteht.

**4.** Superlegierung nach Anspruch 1, die, in Masseprozent, 5,0 bis 6,0 % Aluminium, 8,5 bis 9,5 % Tantal, 0 bis 1,50 % Titan, 8,0 bis 10,0 % Kobalt, 6,0 bis 7,0 % Chrom, 0,30 bis 0,90 % Molybdän, 5,5 bis 6,5 % Wolfram, 0 bis 1,50 % Rhenium, 0,05 bis 0,15 % Hafnium, 1,70 bis 3,30 % Platin, 0 bis 0,15 % Silizium umfasst, wobei der Rest aus Nickel und unvermeidlichen Verunreinigungen besteht.

**5.** Superlegierung nach Anspruch 1, die, in Masseprozent, 5,0 bis 6,0 % Aluminium, 6,0 bis 9,5 % Tantal, 8,0 bis 10,0 % Kobalt, 6,0 bis 7,0 % Chrom, 0,30 bis 0,90 % Molybdän, 5,5 bis 6,5 % Wolfram, 0,05 bis 0,15 % Hafnium, 2,70 bis 4,30 % Platin, 0 bis 0,15 % Silizium umfasst, wobei der Rest aus Nickel und unvermeidlichen Verunreinigungen besteht.

**6.** Superlegierung nach Anspruch 1, die, in Masseprozent, 5,0 bis 6,0 % Aluminium, 6,0 bis 9,5 % Tantal, 0,50 bis 1,50 % Titan, 8,0 bis 10,0 % Kobalt, 6,0 bis 7,0 % Chrom, 0,30 bis 0,90 % Molybdän, 5,5 bis 6,5 % Wolfram, 0,05 bis 0,15 % Hafnium, 2,70 bis 4,30 % Platin, 0 bis 0,15 % Silizium umfasst, wobei der Rest aus Nickel und unvermeidlichen Verunreinigungen besteht.

**7.** Superlegierung nach Anspruch 1, die, in Masseprozent, 5,0 bis 6,0 % Aluminium, 6,0 bis 9,5 % Tantal, 0,8 bis 1,20 % Titan, 8,0 bis 10,0 % Kobalt, 6,0 bis 7,0 % Chrom, 0,30 bis 0,90 % Molybdän, 5,5 bis 6,5 % Wolfram, 0 bis 2,50 % Rhenium, 0,05 bis 0,15 % Hafnium, 0,70 bis 3,30 % Platin, 0 bis 0,15 % Silizium umfasst, wobei der Rest aus Nickel und unvermeidlichen Verunreinigungen besteht.

**8.** Superlegierung nach Anspruch 1, die, in Masseprozent, 5,0 bis 6,0 % Aluminium, 6,0 bis 9,5 % Tantal, 0 bis 1,50 % Titan, 8,0 bis 10,0 % Kobalt, 6,0 bis 7,0 % Chrom, 0,30 bis 0,90 % Molybdän, 5,5 bis 6,5 % Wolfram, 0 bis 2,50 % Rhenium, 0,05 bis 0,15 % Hafnium, 0,70 bis 4,30 % Platin, 0,10 % Silizium umfasst, wobei der Rest aus Nickel und unvermeidlichen Verunreinigungen besteht.

**9.** Superlegierung nach Anspruch 1, die, in Masseprozent, 5,0 bis 6,0 % Aluminium, 6,0 bis 7,0 % Tantal, 0,8 bis 1,20 % Titan, 8,0 bis 10,0 % Kobalt, 6,0 bis 7,0 % Chrom, 0,30 bis 0,90 % Molybdän, 5,5 bis 6,5 % Wolfram, 0,05 bis 0,15 % Hafnium, 2,70 bis 3,30 % Platin, 0 bis 0,15 % Silizium umfasst, wobei der Rest aus Nickel und unvermeidlichen Verunreinigungen besteht.

**10.** Superlegierung nach Anspruch 1, die, in Masseprozent, 5,0 bis 6,0 % Aluminium, 6,0 bis 7,0 % Tantal, 0,8 bis 1,20 % Titan, 8,0 bis 10,0 % Kobalt, 6,0 bis 7,0 % Chrom, 0,30 bis 0,90 % Molybdän, 5,5 bis 6,5 % Wolfram, 0,70 bis 1,30 % Rhenium, 0,05 bis 0,15 % Hafnium, 1,70 bis 2,30 % Platin, 0 bis 0,15 % Silizium umfasst, wobei der Rest aus Nickel und unvermeidlichen Verunreinigungen besteht.

**11.** Superlegierung nach Anspruch 1, die, in Masseprozent, 5,0 bis 6,0 % Aluminium, 6,0 bis 7,0 % Tantal, 0,8 bis 1,20 % Titan, 8,0 bis 10,0 % Kobalt, 6,0 bis 7,0 % Chrom, 0,30 bis 0,90 % Molybdän, 5,5 bis 6,5 % Wolfram, 1,70 bis 2,30 % Rhenium, 0,05 bis 0,15 % Hafnium, 0,70 bis 1,30 % Platin, 0 bis 0,15 % Silizium umfasst, wobei der Rest aus Nickel und unvermeidlichen Verunreinigungen besteht.

12. Superlegierung nach Anspruch 1, die, in Masseprozent, 5,0 bis 6,0 % Aluminium, 6,0 bis 7,0 % Tantal, 8,0 bis 10,0 % Kobalt, 6,0 bis 7,0 % Chrom, 0,30 bis 0,90 % Molybdän, 5,5 bis 6,5 % Wolfram, 0,05 bis 0,15 % Hafnium, 3,70 bis 4,30 % Platin, 0 bis 0,15 % Silizium umfasst, wobei der Rest aus Nickel und unvermeidlichen Verunreinigungen besteht.

13. Superlegierung nach Anspruch 1, die, in Masseprozent, 5,0 bis 6,0 % Aluminium, 8,5 bis 9,5 % Tantal, 0,8 bis 1,20 % Titan, 8,0 bis 10,0 % Kobalt, 6,0 bis 7,0 % Chrom, 0,30 bis 0,90 % Molybdän, 5,5 bis 6,5 % Wolfram, 0,70 bis 2,30 % Rhenium, 0,05 bis 0,15 % Hafnium, 1,70 bis 2,30 % Platin, 0 bis 0,15 % Silizium umfasst, wobei der Rest aus Nickel und unvermeidlichen Verunreinigungen besteht.

14. Superlegierung nach Anspruch 1, die, in Masseprozent, 5,0 bis 6,0 % Aluminium, 8,5 bis 9,5 % Tantal, 8,0 bis 10,0 % Kobalt, 6,0 bis 7,0 % Chrom, 0,30 bis 0,90 % Molybdän, 5,5 bis 6,5 % Wolfram, 0,05 bis 0,15 % Hafnium, 2,70 bis 3,30 % Platin, 0 bis 0,15 % Silizium umfasst, wobei der Rest aus Nickel und unvermeidlichen Verunreinigungen besteht.

15. Superlegierung nach Anspruch 1, die, in Masseprozent, 5,0 bis 6,0 % Aluminium, 8,5 bis 9,5 % Tantal, 0,80 bis 1,20 % Titan, 8,0 bis 10,0 % Kobalt, 6,0 bis 7,0 % Chrom, 0,30 bis 0,90 % Molybdän, 5,5 bis 6,5 % Wolfram, 0,05 bis 0,15 % Hafnium, 2,70 bis 3,30 % Platin, 0,10 % Silizium umfasst, wobei der Rest aus Nickel und unvermeidlichen Verunreinigungen besteht.

16. Einkristalline Schaufel (20A, 20B) für Turbomaschine, die eine Superlegierung nach einem der Ansprüche 1 bis 15 umfasst.

17. Schaufel (20A, 20B) nach Anspruch 16, die eine Schutzbeschichtung umfasst, die eine metallische Unterschicht, die auf der Superlegierung aufgebracht ist, und eine keramische thermische Barriere umfasst, die auf der metallischen Unterschicht aufgebracht ist.

18. Schaufel (20A, 20B) nach Anspruch 16 oder 17, die eine gemäß einer kristallographischen Richtung <001> ausgerichtete Struktur aufweist.

19. Turbomaschine, die eine Schaufel (20A, 20B) nach einem der Ansprüche 16 bis 18 umfasst.

## Claims

1. A nickel-based superalloy comprising, in percentages by mass, 5.0 to 6.0% aluminum, 6.0 to 9.5% tantalum, 0 to 1.50% titanium, 8.0 to 10.0% cobalt, 6.0 to 7.0% chromium, 0.30 to 0.90% molybdenum, 5.5 to 6.5% tungsten, 0 to 2.50% rhenium, 0.05 to 0.15% hafnium, 0.70 to 4.30% platinum, 0 to 0.15% silicon, the remainder being nickel and unavoidable impurities.

2. The superalloy as claimed in claim 1, comprising, in percentages by mass, 5.0 to 6.0% aluminum, 6.0 to 9.5% tantalum, 0 to 1.50% titanium, 8.0 to 10.0% cobalt, 6.0 to 7.0% chromium, 0.30 to 0.90% molybdenum, 5.5 to 6.5% tungsten, 0 to 2.50% rhenium, 0.05 to 0.15% hafnium, 1.70 to 4.30% platinum, 0 to 0.15% silicon, the remainder being nickel and unavoidable impurities.

3. The superalloy as claimed in claim 1, comprising, in percentages by mass, 5.0 to 6.0% aluminum, 6.0 to 7.0% tantalum, 0 to 1.50% titanium, 8.0 to 10.0% cobalt, 6.0 to 7.0% chromium, 0.30 to 0.90% molybdenum, 5.5 to 6.5% tungsten, 0 to 2.50% rhenium, 0.05 to 0.15% hafnium, 1.70 to 4.30% platinum, 0 to 0.15% silicon, the remainder being nickel and unavoidable impurities.

4. The superalloy as claimed in claim 1, comprising, in percentages by mass, 5.0 to 6.0% aluminum, 8.5 to 9.5% tantalum, 0 to 1.50% titanium, 8.0 to 10.0% cobalt, 6.0 to 7.0% chromium, 0.30 to 0.90% molybdenum, 5.5 to 6.5% tungsten, 0 to 1.50% rhenium, 0.05 to 0.15% hafnium, 1.70 to 3.30% platinum, 0 to 0.15% silicon, the remainder being nickel and unavoidable impurities.

5. The superalloy as claimed in claim 1, comprising, in percentages by mass, 5.0 to 6.0% aluminum, 6.0 to 9.5% tantalum, 8.0 to 10.0% cobalt, 6.0 to 7.0% chromium, 0.30 to 0.90% molybdenum, 5.5 to 6.5% tungsten, 0.05 to 0.15% hafnium, 2.70 to 4.30% platinum, 0 to 0.15% silicon, the remainder being nickel and unavoidable impurities.

6. The superalloy as claimed in claim 1, comprising, in percentages by mass, 5.0 to 6.0% aluminum, 6.0 to 9.5% tantalum, 0.50 to 1.50% titanium, 8.0 to 10.0% cobalt, 6.0 to 7.0% chromium, 0,30 to 0.90% molybdenum, 5.5 to 6.5% tungsten, 0.05 to 0.15% hafnium, 2.70 to 4.30% platinum, 0 to 0.15% silicon, the remainder being nickel and unavoidable impurities.

7. The superalloy as claimed in claim 1, comprising, in percentages by mass, 5.0 to 6.0% aluminum, 6.0 to 9.5% tantalum, 0.80 to 1.20% titanium, 8.0 to 10.0% cobalt, 6.0 to 7.0% chromium, 0.30 to 0.90% molybdenum, 5.5 to 6.5% tungsten, 0 to 2.50% rhenium, 0.05 to 0.15% hafnium, 0.70 to 3.30% platinum, 0 to 0.15% silicon, the remainder being nickel and unavoidable impurities.

8. The superalloy as claimed in claim 1, comprising, in percentages by mass, 5.0 to 6.0% aluminum, 6.0 to 9.5% tantalum, 0 to 1.50% titanium, 8.0 to 10.0% cobalt, 6.0 to 7.0% chromium, 0.30 to 0.90% molybdenum, 5.5 to 6.5% tungsten, 0 to 2.50% rhenium, 0.05 to 0.15% hafnium, 0.70 to 4.30% platinum, 0.10% silicon, the remainder being nickel and unavoidable impurities.

9. The superalloy as claimed in claim 1, comprising, in percentages by mass, 5.0 to 6.0% aluminum, 6.0 to 7.0% tantalum, 0.80 to 1.20% titanium, 8.0 to 10.0% cobalt, 6.0 to 7.0% chromium, 0,30 to 0.90% molybdenum, 5.5 to 6.5% tungsten, 0.05 to 0.15% hafnium, 2.70 to 3.30% platinum, 0 to 0.15% silicon, the remainder being nickel and unavoidable impurities.

10. The superalloy as claimed in claim 1, comprising, in percentages by mass, 5.0 to 6.0% aluminum, 6.0 to 7.0% tantalum, 0.80 to 1.20% titanium, 8.0 to 10.0% cobalt, 6.0 to 7.0% chromium, 0.30 to 0.90% molybdenum, 5.5 to 6.5% tungsten, 0.70 to 1.30% rhenium, 0.05 to 0.15% hafnium, 1.70 to 2.30% platinum, 0 to 0.15% silicon, the remainder being nickel and unavoidable impurities.

11. The superalloy as claimed in claim 1, comprising, in percentages by mass, 5.0 to 6.0% aluminum, 6.0 to 7.0% tantalum, 0.80 to 1.20% titanium, 8.0 to 10.0% cobalt, 6.0 to 7.0% chromium, 0.30 to 0.90% molybdenum, 5.5 to 6.5% tungsten, 1.70 to 2.30% rhenium, 0.05 to 0.15% hafnium, 0.70 to 1.30% platinum, 0 to 0.15% silicon, the remainder being nickel and unavoidable impurities.

12. The superalloy as claimed in claim 1, comprising, in percentages by mass, 5.0 to 6.0% aluminum, 6.0 to 7.0% tantalum, 8.0 to 10.0% cobalt, 6.0 to 7.0% chromium, 0.30 to 0.90% molybdenum, 5.5 to 6.5% tungsten, 0.05 to 0.15% hafnium, 3.70 to 4.30% platinum, 0 to 0.15% silicon, the remainder being nickel and unavoidable impurities.

13. The superalloy as claimed in claim 1, comprising, in percentages by mass, 5.0 to 6.0% aluminum, 8.5 to 9.5% tantalum, 0.80 to 1.20% titanium, 8.0 to 10.0% cobalt, 6.0 to 7.0% chromium, 0.30 to 0.90% molybdenum, 5.5 to 6.5% tungsten, 0.70 to 2.30% rhenium, 0.05 to 0.15% hafnium, 1.70 to 2.30% platinum, 0 to 0.15% silicon, the remainder being nickel and unavoidable impurities.

14. The superalloy as claimed in claim 1, comprising, in percentages by mass, 5.0 to 6.0% aluminum, 8.5 to 9.5% tantalum, 8.0 to 10.0% cobalt, 6.0 to 7.0% chromium, 0.30 to 0.90% molybdenum, 5.5 to 6.5% tungsten, 0.05 to 0.15% hafnium, 2.70 to 3.30% platinum, 0 to 0.15% silicon, the remainder being nickel and unavoidable impurities.

15. The superalloy as claimed in claim 1, comprising, in percentages by mass, 5.0 to 6.0% aluminum, 8.5 to 9.5% tantalum, 0.80 to 1.20% titanium, 8.0 to 10.0% cobalt, 6.0 to 7.0% chromium, 0,30 to 0.90% molybdenum, 5.5 to 6.5% tungsten, 0.05 to 0.15% hafnium, 2.70 to 3.30% platinum, 0.10% silicon, the remainder being nickel and unavoidable impurities.

16. A single-crystal blade (20A, 20B) for a turbomachine comprising a superalloy as claimed in any one of claims 1 to 15.

17. The blade (20A, 20B) as claimed in claim 16, comprising a protective coating comprising a metallic bond coat deposited on the superalloy and a ceramic thermal barrier deposited on the metallic bond coat.

18. The blade (20A, 20B) as claimed in claim 16 or 17, having a structure oriented in a <001> crystallographic direction.

**EP 3 802 895 B1**

**19.** A turbomachine comprising a blade (20A, 20B) as claimed in any one of claims 16 to 18.

**17**

FIG.1

FIG.2

FIG.3

FIG.4

FIG.5

FIG.6

FIG.7

FIG.8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2018078246 A
- US 5888451 A
- US 5270123 A

**Littérature non-brevet citée dans la description**

- **J. S. VAN SLUYTMAN ; C. J. MOCERI ; T. M. POLLOCK.** A Pt-modified Ni-base superalloy with high temperature precipitate stability. *Mater. Sci. Eng. A,* Juillet 2015, vol. 639, 747-754
- **F.C. HULL.** *Metal Progress,* Novembre 1969, 139-140
- **P. CARONDANS.** *High gamma prime solvus New Generation Nickel-Based Superalloys for Single Crystal turbine Balde Applications,* 2000, 737-746